# EUROPEAN PATENT APPLICATION

(11) **EP 1 944 613 A1**
(43) Date of publication of application: **16.07.2008**
(21) Application number: 07110808.8
(22) Date of filing: 21.06.2007
(51) Int. Cl.: G01R 1/073, G01R 3/00

(54) **Probe card for test and manufacturing method thereof**

(30) Priority: 12.01.2007 KR 20070003621
(71) Applicant: Apex International, Inc., Suwon City, Kyungki-do (KR)
(72) Inventor: Rhyu, Dal-Lae, Suwon-si Gyeonggi-do (KR)
(74) Representative: Modiano, Micaela Nadia

(57) **Abstract**

A probe card includes a plurality of probe modules (1000), a multi-layer ceramic substrate (2000) provided below the probe module, and a solder ball (183) for connecting the probe module and the multi-layer ceramic substrate, and the height (H) of the solder ball is controlled depending on location of the multi-layer ceramic substrate. Therefore, the probe card and manufacturing method thereof improves the accuracy of the test process by matching the height of the probe of the probe module and the reference planarization line when a planarity of the multi-layer ceramic substrate is bad or is varied during the probe card assembling process.

## Description

### BACKGROUND OF THE INVENTION

### (a) Field of the Invention

The present invention relates to a probe card and a manufacturing method thereof, and more particularly relates to a probe card including a probe for electrically testing a malfunction of a semiconductor integrated circuit formed on a semiconductor wafer and a manufacturing method thereof.

### (b) Description of the Related Art

In general, a semiconductor integrated circuit (IC) device is made using a predetermined semiconductor manufacturing process. An electrical test is applied during or after the manufacturing process to determine what products are non-functional. In the electrical test, a test equipment for receiving various electrical signals from the outside, detecting response signals of the semiconductor integrated circuit, and analyzing the response signals is used Thus, a probe for electrically connecting the test equipment and the semiconductor integrated circuit is needed. A similar test process is performed during or after the manufacturing process of flat panel displays such as liquid crystal displays (LCDs), and a probe for electrically connecting the test equipment and elements is also needed.

A probe card device on which a probe is formed, includes a plurality of probe modules having a plurality of probles, a multi-layer ceramic substrate (MLC), and a flexible printed circuit (FPC), and performs a test process. The plurality of probe modules are attached on the multi-layer ceramic substrate through a solder ball. The multi-layer ceramic substrate is connected to the flexible printed circuit (FPC) with a pogo block therebetween.

When a planarity of the multi-layer ceramic substrate is not uniform, the height of the probe of the probe module disposed thereon may not be uniform. Therefore, the accuracy of the test process is easily deteriorated

### SUMMARY OF THE INVENTION

Accordingly, the present invention has been made to solve the above-mentioned problems occurring in the prior art, and an object of the present invention is to provide a probe card with improved planarity and a manufacturing method thereof. In one embodiment of the present invention, a probe card includes a plurality of probe modules; a ceramic substrate provided below the probe module; and a solder ball for connecting the probe module and the ceramic substrate, and a height of the solder ball is controlled depending on location of the ceramic substrate. The height of the solder ball is different for the respective probe module The height of the solder ball is increased as it goes from the center of the ceramic substrate to the surroundings thereof Or, the height of the solder ball is decreased as it goes from the center of the ceramic substrate to the surroundings thereof The heights of the probe modules interact with each other. The probe module includes a base substrate and a plurality of probes formed on the base substrate, and the height of the probe module is an upper end of the probe of the probe module. The probe card further includes a circuit formed below the base substrate and having a first solder pad; a first solder resist covering the circuit and having a first contact hole for exposing the first solder pad; and a first under bump metallurgy (UBM) layer formed on the first solder resist, and the solder ball attached to the first UBM layer. The probe card further includes a second solder pad formed on the ceramic substrate; a second solder resist having a second contact hole for exposing the second solder pad; and a second under bump metallurgy (UBM) layer formed on the second solder resist, and the solder ball attached to the second UBM layer.

In another embodiment of the present invention, a method for manufacturing a probe card includes: preparing a plurality of probe modules to which a solder ball is attached; picking up at least one of the probe modules by using a pickup device, and attaching the probe module to the ceramic substrate, and controlling the height of the solder ball by lifting or lowering the pickup device, and controlling the height of the probe module. The picking up of at least one of the probe modules includes contacting the solder ball of the picked-up probe module to the ceramic substrate, and heating the solder ball. The heating of the solder ball is performed by applying a laser to the probe module through the pickup device or using a heat source. The preparing of the plurality of probe modules includes attaching the solder ball to the solder pad of the probe module of a wafer on which the plurality of probe modules are formed, and separating the probe module to which the solder ball is attached from the wafer and loading the probe module on a module tray. The controlling of the height of the solder ball includes controlling the height of the solder ball depending on the location on the ceramic substrate of the probe module The height of the solder ball is controlled to increase as it goes to the surroundings of the ceramic substrate from the center thereof. Or, the height of the solder ball is controlled to decrease as it goes to the surroundings of the ceramic substrate from the center thereof. The pickup device contacted to an upper surface of the probe module picks up the probe module by using vacuum.

### BRIEF DESCRIPTION OF THE DRAWINGS

The above and other objects, features, and advantages of the present invention will be more apparent from the following detailed description taken in conjunction with the accompanying drawings, in which:
FIG. 1 is a perspective view of a probe card according to an embodiment of the present invention,
FIG. 2 is a cross-sectional view taken along the line II-II of FIG. 1;
FIG. 3 is a top plan view of an enlarged view of the probe module of FIG. 2;
FIG. 4 is a cross-sectional view taken along the line IV-IV of FIG. 3;
FIG 5 is a cross-sectional view of FIG 1 when the center of a reference plane line is higher than the surroundings;
FIG, 6 is a cross-sectional view of FIG. 1 when the surroundings of a reference planarization line are higher than the center;
FIG. 7 is a schematic view illustrating the step for separating a probe module from a base substrate;
FIG. 8 is a schematic view illustrating the step for picking up the separated probe module by using a pickup device, and moving the same to the multi-layer ceramic substrate;
FIG 9 is a cross-sectional view illustrating the step for attaching a solder ball of the probe module to the surrounding of the multi-layer ceramic substrate by using a pickup device;
FIG. 10 is a cross-sectional view illustrating the step for increasing the height of the solder ball to match the height of the probe module and the reference planarization line by using a pickup device; and
FIG. 11 is a cross-sectional view illustrating the step for attaching another probe module to the center of the multi-layer ceramic substrate to match the height of the probe module and the reference planarization line.

### DETAILED DESCRIPTION OF THE EMBODIMENTS

Hereinafter, a preferred embodiment of the present invention will be described with reference to the accompanying drawings. As those skilled in the art would realize, the described embodiments may be modified in various different ways, all without departing from the spirit or scope of the present invention. In the following description of the present invention, a detailed description of known functions and configurations incorporated herein will be omitted when it may make the subject matter of the present invention unclear

A probe card and a manufacturing method thereof according to an embodiment of the present invention will now be described with reference to drawings.

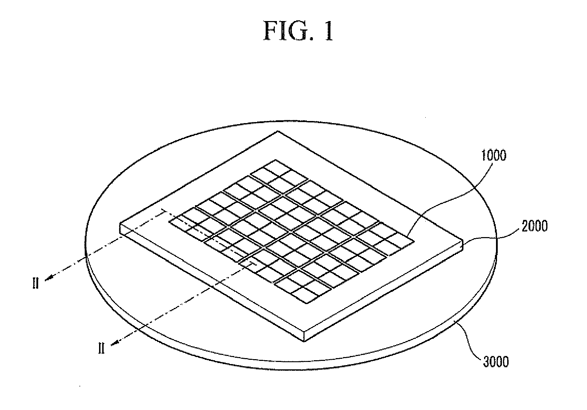

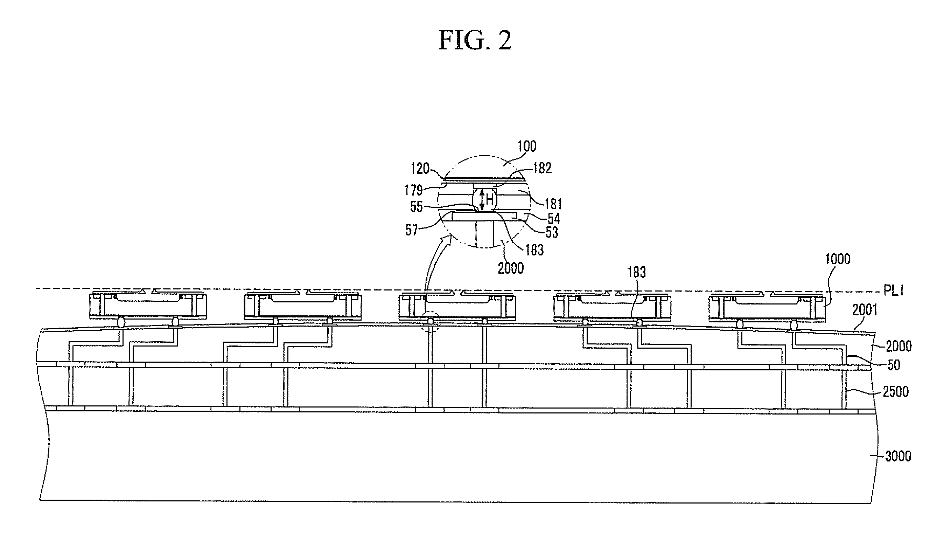

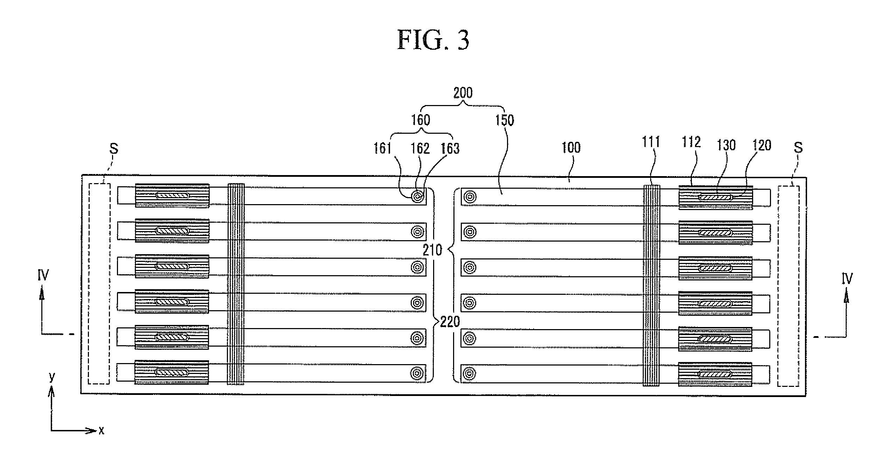

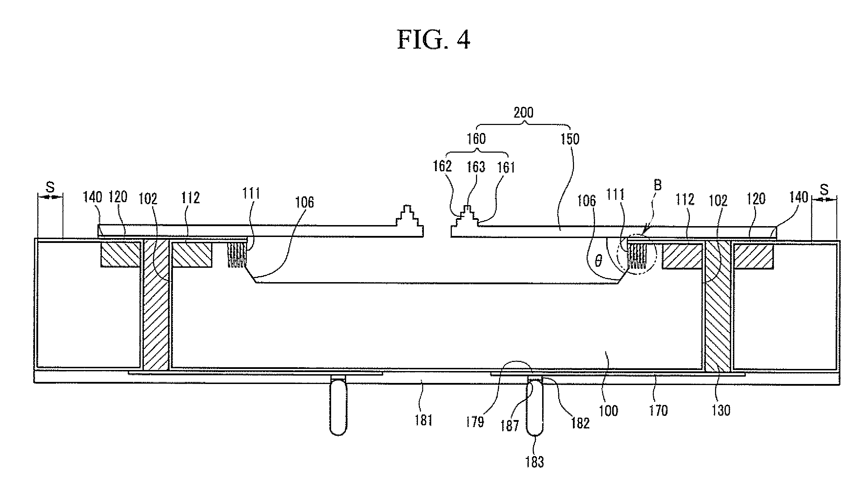

FIG. 1 is a perspective view of a probe card according to an embodiment of the present invention, FIG. 2 is a cross-sectional view taken along the line II-II of FIG, 1, FIG 3 is a top plan view of an enlarged probe module of FIG. 2, and FIG 4 is a cross-sectional view taken along the line IV-IV of FIG. 3

As shown in FIGs 1 and 2, the probe card includes a plurality of probe modules 1000, a multi-layer ceramic substrate 2000 provided below the probe modules 1000, and a flexible printed circuit (FPC) 3000 provided below the multi-layer ceramic substrate 2000. Preferably, the multi-layer ceramic substrate 2000 is connected to the flexible printed circuit (FPC) 3000 with a pogo block 2500 therebetween.

As shown in FIGs. 3 and 4, the respective probe module 1000 includes a base substrate 100, and a plurality of probes 200 formed on the base substrate 100. The base substrate 100 is preferably made of a single crystal silicon wafer, and an insulation layer 120 is formed on the surface of the base substrate 100.

A trench oxide layer 111 is formed around an upper surface of the base substrate 100, a through hole 102 is formed with a predetermined distance from the trench oxide layer 111, and a connection member 130 fills the through hole 102. The trench oxide layer 111 is generated by using a thermal oxide layer, thereby providing excellent electrical insulation and hardness.

The probe 200 includes a beam 150 electrically connected to the connection member 130 of the base substrate 100, and a contactor 160 formed at the one end of the beam 150 and attached to the beam 150 in the vertical direction The beam 150 is made of one metal of nickel (Ni), copper (Cu), platinum (Pt), palladium (Pd), rhodium (Rh), gold (Au), and aluminum (Al), or an alloy made of one of the metals as a major element and other metals as minor elements. The plurality of probes 200 configuring the probe module 1000 include a first probe group 210 and a second probe group 220 facing with each other One end at which the contactor 160 of the probes 200 of the first probe group 210 faces the other end at which the contactor 160 of the probes 200 of the second probe group 220. Therefore, a plurality of contactors 160 formed in a probe module 1000 are arranged in two columns in the Y direction

The contactor 160 has a staircase-shaped sidewall and a diameter of an upper part thereof is less than that of a lower part thereof. The contactor 160 includes a first tip 161 contacted to the beam 150, a second tip 162 formed on the first tip 161 with a diameter being less than that of the first tip 161, and a third tip 163 formed on the second tip 162 with a diameter being less than that of the second tip 162. Preferably, the cross-sections of the first, second and third tips 161, 162, and 163 are variable such as circular-shaped, oval-shaped, or polygonal-shaped The contactor 160 electrically connects the probe substrate of the test equipment and the semiconductor integrated circuit in the electrical test.

In the embodiment of the present invention, the contactor 160 has three tips 161, 162, and 163, and in addition, the number of tips of contractor 160 is not limited to three.

A seed layer 140 is attached below the beam 150, and the seed layer 140 is made of one of nickel (Ni), copper (Cu), platinum (Pt), palladium (Pd), rhodium (Rh), gold (Au), and aluminum (Al), or an alloy made of one metal thereof as a major element and other metals as minor elements

A predetermined part of the base substrate 100 provided on the lower part of the beam 150 is removed to form a bending space (A) in which the beam 150 is bent upwards and downwards. The beam 150 and the predetermined part of the base substrate 100 are spaced with a predetermined gap therebetween for providing the bending space (A), and the beam 150 moves elastically and minutely upwards and downwards in the bending space (A)

Preferably, a sidewall 106 of the bending space (A) has a slope, and the upper part of the sidewall 106 contacts the beam 150 Thus, the sidewall 106 of the bending space (A) and the beam 150 has a predetermined angle (θ) therebetween

The trench oxide layer 111 is provided at the boundary between the beam 150 and the sidewall 106 of the bending space (A), that is, the boundary (B) between the beam 150 and the base substrate 100. More particularly, the trench oxide layer 111 is formed around the sidewall 106 of the bending space (A). Therefore, the trench oxide layer 111 prevents the boundary (B) from being damaged because of stress applied to the boundary (B) between the beam 150 and the base substrate 100 by the repeated bending operation of the beam 150, and prevents electricity leakage by maintaining electrical insulation between the beam 150 and the base substrate 100.

As shown in FIG. 3, the trench oxide layer 111 is provided in the Y direction being perpendicular to the X direction of the beam 150.

An auxiliary trench oxide layer 112 is formed around the connection member 130, and the auxiliary trench oxide layer 112 is provided in the X direction with respect to the Y direction of the trench oxide layer 111. The auxiliary trench oxide layer 112 is provided in the X direction so as to prevent the connection member 130 from being damaged when the base substrate 100 is bent in the Y direction by the trench oxide layer 111.

An insulation layer 120 is formed at a space between the base substrate 100 and the seed layer 140 other than on the surface of the bending space A. The connection member 130 and the beam 150 contact each other with the seed layer 140 as a medium.

Another end of the beam 154 is connected to a circuit 170 formed below the support substrate 100 through the connection member 130 A first solder pad 179 is formed on one end of the circuit 170, and a first solder resist 181 having a first contact hole 187 exposing the first solder pad 179 covers the circuit 170. A first under bump metallurgy (UBM) layer 182 is formed on the first solder pad 179 exposed through the first contact hole 187, and a solder ball 183 is attached on the first UBM layer 182. The first UBM layer 182 includes a diffusion barrier layer such as titanium (Ti) for preventing diffusion of the solder ball 183, and a wettability layer such as gold (Au) or copper (Cu) for increasing the wettability of the solder ball 183 The solder ball 183 is made of an alloy of gold (Au) and tin (Sn) or an alloy of tin (Sn), platinum (Pt), and copper (Cu). The size of the solder ball 183 is preferably ranged from several tens of to several hundreds of

As shown in FIG. 2, an internal circuit 50 is formed in the multi-layer ceramic substrate 2000 A second solder pad 53 connected to the internal circuit 50 is formed on the multi-layer ceramic substrate 2000 A second solder resist 54 having a second contact hole 57 exposing the second solder pad 53 is formed on the multi-layer ceramic substrate 2000. A second UBM layer 55 is formed on the second scalder pad 53 exposed through the second contact hole 57, and a solder ball 183 is attached on the second UBM layer 55 The second UBM layer 55 includes a diffusion barrier layer such as nickel (Ni) for preventing diffusion of the solder ball 183, and a wettability layer such as gold (Au) or copper (Cu) for increasing wettability of the solder ball 183 Another surface of the solder ball 183 attached to the first solder pad 179 of the probe module 1000 is attached to the second solder pad 53, and the first solder pad 179 and the second solder pad 53 are electrically connected with each other through the solder ball 183.

The plurality of probe modules 1000 are attached to the multi-layer ceramic substrate 2000, and the height H of the respective solder ball 183 of the probe module 1000 is controlled depending on the planarity of the multi-layer ceramic substrate 2000

More particularly, when the center of the multi-layer ceramic substrate 2000 is convex, the height H of the solder ball 183 of the probe module 1000 provided in the center of the multi-layer ceramic substrate 2000 from among the probe modules 1000 is set to be decreased, while the height H of the solder ball 183 of the probe module 1000 is set to be increased as it goes to the surroundings of the multi-layer ceramic substrate 2000 Here, the height H of the solder ball 183 is the vertical diameter of the solder ball 183 influencing the height Since the height H of the solder ball 813 of the probe module 1000 is changed depending on the planarity of the multi-layer ceramic substrate 2000, the height of the probes 200 of the probe modules 1000 corresponds to a reference planarization line PL1

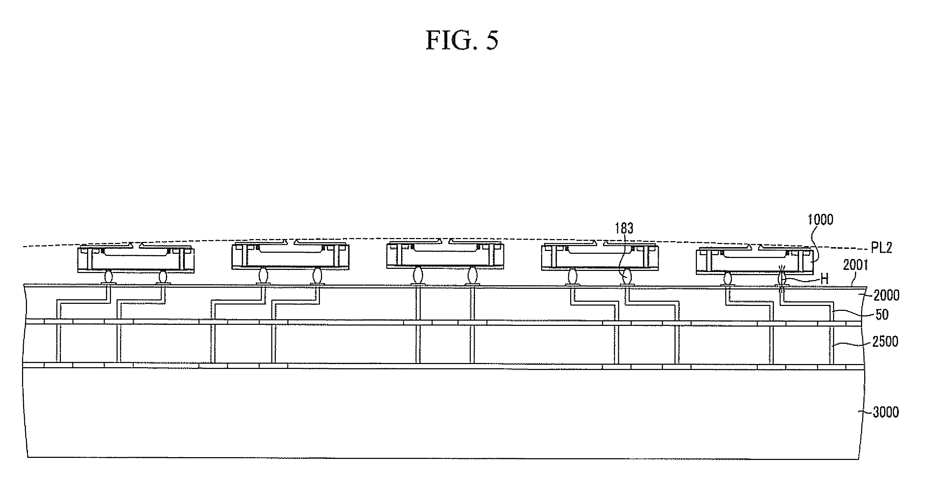

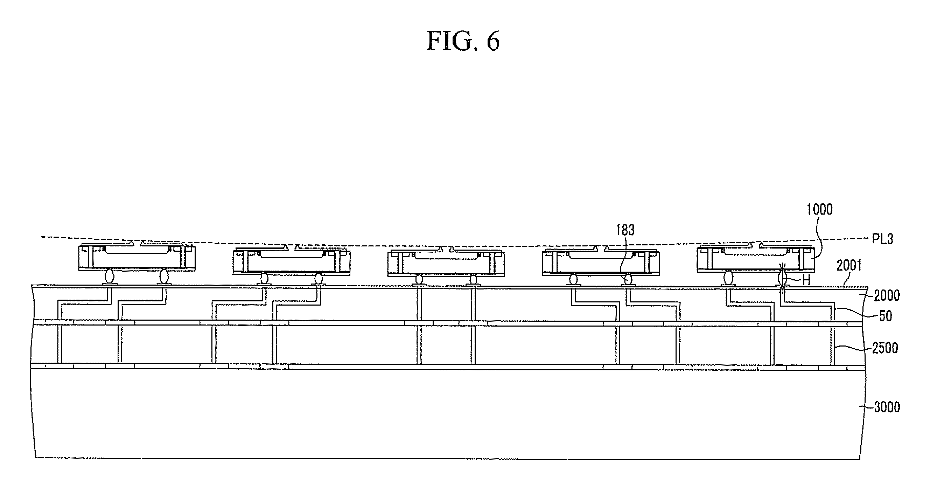

The reference planarization lines PL1 are the same as shown in FIG 2, and part of the reference planarization lines PL can be lower or higher as shown in FIGs. 5 and 6.

The center of the reference planarization line PL2 is higher than the surroundings in FIG 5, and the surroundings of the reference planarization line PL3 are higher than the center thereof in FIG. 6.

As shown in FIG. 5, when the center of the reference planarization line PL2 is higher than the surroundings, the height H of the solder ball 183 of the probe module 1000 provided in the center of the multi-layer ceramic substrate 2000 from among a plurality of probe modules 1000 is formed to be high, and the height H of the solder ball 183 of the probe module 1000 is formed to be low as it goes to the surroundings of the multi-layer ceramic substrate 2000 in the condition that the upper surface 2001 of the multi-layer ceramic substrate 2000 is plain.

Also, as shown in FIG. 6, when the center of the reference planarization line PL3 is lower than the surroundings, the height of the solder ball 183 of the probe module 1000 provided in the center of the multi-layer ceramic substrate 2000 from among a plurality of probe modules 1000 is formed to be low, and the height of the solder ball 183 of the probe module 1000 is formed to be high as it goes to the surroundings of the multi-layer ceramic substrate 2000 in the condition that the upper surface 2001 of the multi-layer ceramic substrate 2000 is plain

FIGs. 5 and 6 show that the height H of the respective solder ball 183 is changed depending on the location of the multi-layer ceramic substrate 2000 Thus, the height H of the solder ball 183 is variable for the respective probe modules 1000.

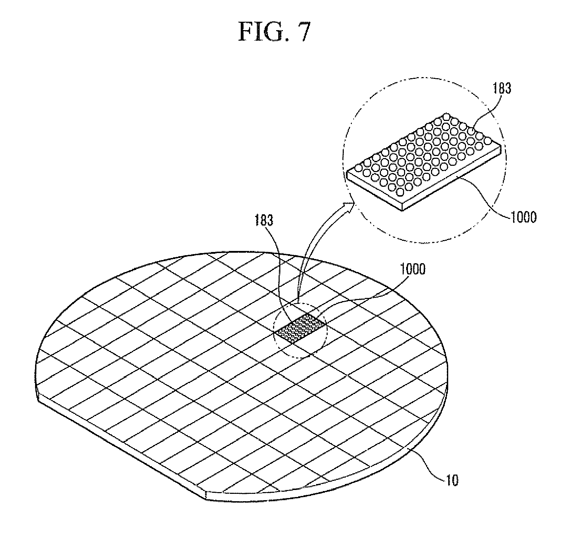

FIGs 7 to 11 show a probe substrate manufacturing method according to an embodiment of the present invention.

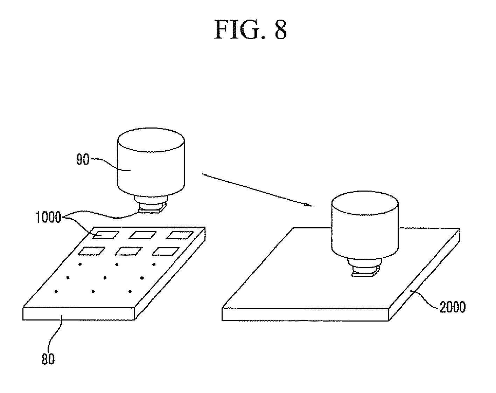

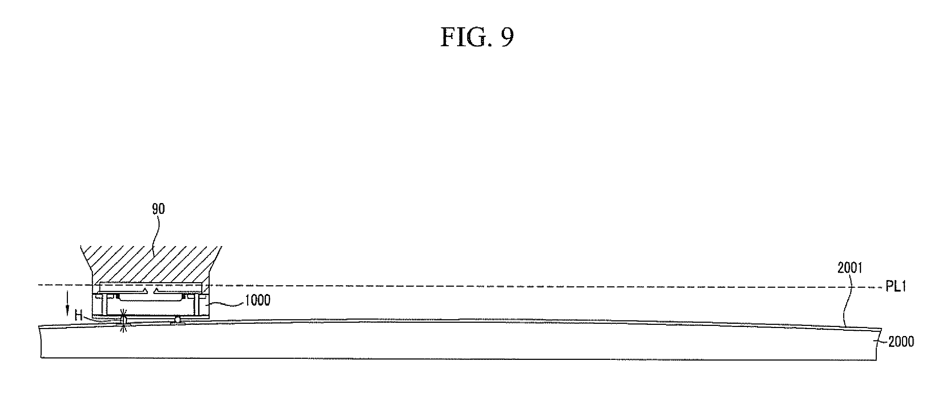

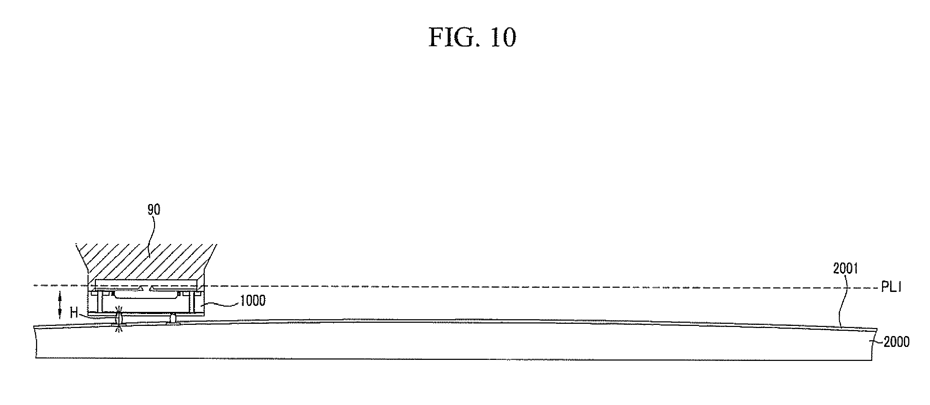

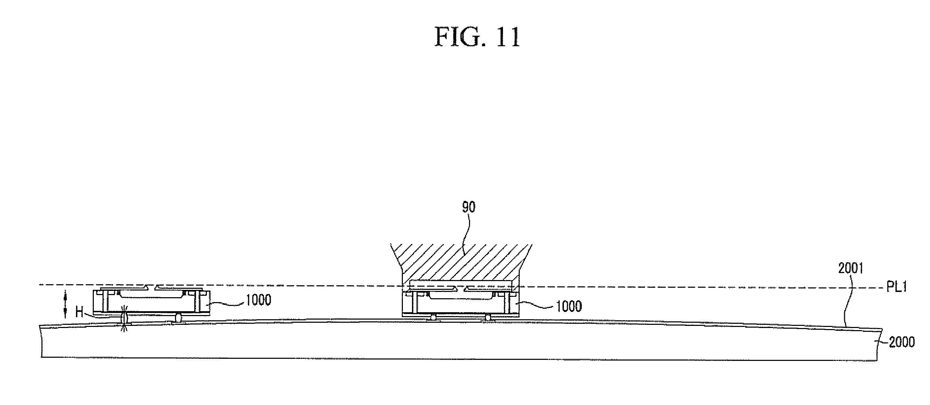

FIG. 7 shows a probe substrate manufacturing method according to an embodiment of the present invention, illustrating the step for separating a probe module from a base substrate, FIG 8 shows the step for picking up the separated probe module by using a pickup device, and moving the separated probe module to the multi-layer ceramic substrate, FIG. 9 shows the step for attaching a solder ball of the probe module to the surrounding of the multi-layer ceramic substrate by using a pickup device, FIG 10 shows the step for increasing the vertical diameter of the solder ball to match the height of the probe module with the reference planarization line by using a pickup device, and FIG 11 shows the step for attaching another probe module to the center of the multi-layer ceramic substrate to match the height of the probe module with the reference planarization line,

As shown in FIG. 7, a plurality of spherical solder balls 183 are provided to a first solder pad 179 (shown in FIG, 2) of the probe module 1000 by using a solder bumper (not shown). A reflow process using laser or other heat sources is performed to firmly attach the solder ball 183 to the first solder pad 179 through the first UBM layer 182. A wafer 10 on which a plurality of probe modules 1000 are formed is cut along a cutting plane line to respectively separate the probe modules 1000.

As shown in FIG. 8, the plurality of probe modules 1000 are arrayed in a module tray 80, one of the probe modules 1000 in the module tray 80 is picked up by using the pickup device 90, and the picked-up probe module 1000 is arranged at a predetermined location of the multi-layer ceramic substrate 2000. The step for attaching a probe module 1000 to surroundings of the multi-layer ceramic substrate 2000 is then performed. The pickup device 90 contacts the surrounding area S of the upper surface of the probe module 1000 and picks up the probe module 1000 by using vacuum

As shown in FIG. 9, the probe module 1000 contacts the multi-layer ceramic substrate 2000 and is pressurized by using the pickup device 90. Laser is applied to the probe module 1000 through an inner space of the pickup device 90 to apply heat so that the solder ball 183 is melted to be attached to the ceramic substrate 2000. Preferably, the solder ball 183 of the probe module 1000 is attached to the second UBM layer 55 of the second solder pad 53 Here, the planarity of the upper surface 2001 of the multi-layer ceramic substrate 2000 may be poor because of the convex form of the center thereof after the manufacturing process. Therefore, the height of the probe module 1000 attached to the surroundings of the multi-layer ceramic substrate 2000 is set to be lower than the reference planarization line PL1 using the above-described process Here, the height of the probe module 1000 is the height of an upper end of the probe 200 of the probe module 1000

As shown in FIG. 10, in order to prevent the height of the probe module 1000 from being lower than the reference planarization line (PL1), the pickup device 90 holding the probe module 1000 is lifted upwards to increase the height H of the solder ball 183 and the height of the probe module 1000 is controlled to correspond to the reference planarization line (PL1) Preferably, the solder ball 183 is a long oval, and the long axis of the oval is in parallel with the vertical direction.

As shown in FIG 11, another probe module 1000 is attached in the center of the multi-layer ceramic substrate 2000 by using the pickup device 90 to match the height of the probe module 1000 and the reference planarization line (PL1). The process shown in FIGs 8 to 10 is repeated to attach the probe modules 1000 to the multi-layer ceramic substrate 2000, and the heights of the probe modules 1000 are controlled to correspond to the reference planarization line (PL1).

In the above, it has been described that a probe module 1000 is attached to the multi-layer ceramic substrate 2000 with poor planarity to match the height of the probe module 1000 and the reference planarization line (PL1) When the planarity of the multi-layer ceramic substrate 2000 is expected to be changed because of the pressure that is applied during the probe card assembling process when the current planarity of the multi-layer ceramic substrate 2000 is good, the height of the probe module 1000 is set to digress from the reference planarization line (PL1) by a predetermined height. Accordingly, when the probe card assembling is finished, the height of the probe module 1000 is controlled to correspond to the reference planarization line (P11)

Differentiating the height of the solder ball 183 for the respective probe modules 1000 is automatically performed by predefining the heights for respective locations in the computer for controlling the pickup device 90

When one of the probe modules 1000 attached to the multi-layer ceramic substrate 2000 is damaged or needs to be replaced, the probe module 1000 may be detached from the multi-layer ceramic substrate 2000, and a probe module 1000 may be attached with the same specification to the multi-layer ceramic substrate 2000, thereby to repair the probe card with easy. When detaching the probe module 1000 from the multi-layer ceramic substrate 2000, the laser is applied to melt the solder ball 183 while holding the probe module 1000 by using the pickup device 90, and the pickup device 90 is lifted.

The probe card and the corresponding manufacturing method improves the accuracy of the test process by matching the height of the probe of the probe module and the reference planarization line when the planarity of the multi-layer ceramic substrate is poor or when the planarity of the multi-layer ceramic substrate is changed during the probe card assembling process

While this invention has been described in connection with what is presently considered to be practical preferred embodiments, it is to be understood that the invention is not limited to the disclosed embodiments, but, on the contrary, is intended to cover various modifications and equivalent arrangements included within the spirit and scope of the appended claims

## Claims

1. A probe card comprising:
a plurality of probe modules;
a ceramic substrate provided below the probe module, and
a solder ball for connecting the probe module and the ceramic substrate,
wherein height of the solder ball is controlled depending on location of the ceramic substrate.

2. The probe card of claim 1, wherein
the height of the solder ball is different for the respective probe module

3. The probe card of claim 2, wherein
the height of the solder ball is increased as it goes from a center of the ceramic substrate to surroundings thereof

4. The probe card of claim 2, wherein
the height of the solder ball is decreased as it goes from the center of the ceramic substrate to the surroundings thereof.

5. The probe card of claim 2, wherein
the heights of the probe modules interact with each other

6. The probe card of claim 5, wherein
the probe module includes a base substrate and a plurality of probes formed on the base substrate, and
the height of the probe module is an upper end of the probe of the probe module.

7. The probe card of claim 6, further comprising:
a circuit formed below the base substrate and having a first solder pad;
a first solder resist covering the circuit and having a first contact hole for exposing the first solder pad; and
a first under bump metallurgy (UBM) layer formed on the first solder resist,
wherein the solder ball is attached to the first UBM layer

8. The probe card of claim 7, further comprising:
a second solder pad formed on the ceramic substrate,
a second solder resist having a second contact hole for exposing the second solder pad; and
a second under bump metallurgy (UBM) layer formed on the second solder resist,
wherein the solder ball is attached to the second UBM layer.

9. A method for manufacturing a probe card comprising;
preparing a plurality of probe modules to which a solder ball is attached;
picking up at least one of the probe modules by using a pickup device, and attaching the probe module to a ceramic substrate; and
controlling the height of the solder ball by lifting or lowering the pickup device, and controlling the height of the probe module

10. The method of claim 9, wherein
the picking up of at least one of the probe modules includes;
contacting the solder ball of the picked-up probe module to the ceramic substrate; and
heating the solder ball.

11. The method of claim 10, wherein
the heating of the solder ball is performed by applying a laser to the probe module using the pickup device or by using a heat source.

12. The method of claim 9, wherein
the preparing of the plurality of probe modules includes:
attaching the solder ball to a solder pad of the probe module of a wafer on which the plurality of probe modules are formed; and
separating the probe module to which the solder ball is attached from the wafer and loading the probe module on a module tray.

13. The method of claim 9, wherein
the controlling of the height of the solder ball includes controlling the height of the solder ball depending on the location of the ceramic substrate of the probe module.

14. The method of claim 13, wherein
the height of the solder ball is controlled to increase as it goes to the surroundings of the ceramic substrate from the center thereof.

15. The method of claim 13, wherein
the height of the solder ball is controlled to decrease as it goes to the surroundings of the ceramic substrate from the center thereof.

16. The method of claim 13, wherein
the pickup device contacted to an upper surface of the probe module picks up the probe module by using vacuum.
